# EUROPEAN PATENT APPLICATION

(11) **EP 1 036 850 A1**
(43) Date of publication of application: **20.09.2000**
(21) Application number: 99924009.6
(22) Date of filing: 11.06.1999
(51) Int. Cl.: C22C 19/03

(54) **Ni-BASED SINGLE CRYSTAL ALLOY HAVING COATING FILM FOR PREVENTING RECRYSTALLIZATION FRACTURE**

(30) Priority: 15.06.1998 JP 16684998
(71) Applicant: Mitsubishi Heavy Industries, Ltd., Tokyo 100-8315 (JP)
(72) Inventor: MORIYA, Keiichi, Mitsubishi Heavy Ind. Ltd., Takasago-chi, Hyogo-ken 676-8686 (JP)
(74) Representative: Goddard, David John
(86) International application number: JP9903136
(87) International publication number: WO9966089

(57) **Abstract**

The present invention relates to a Ni-base single-crystal alloy having a recrystallization crack-proof coating which can prevent intergranular cracks attributable to recrystallization.

Specifically, it provides a Ni-base single-crystal alloy having a recrystallization crack-proof coating which is obtained by providing a Ni-base single-crystal alloy containing no grain boundary strengthening elements or only slight amounts of grain boundary strengthening elements, coating the surface of the Ni-base single-crystal alloy with a layer of a Ni-base alloy containing at least one or more grain boundary strengthening elements selected from the group consisting of Zr, Hf, B and C, and heat-treating the coated Ni-base single-crystal alloy at a temperature which does not cause recrystallization of the Ni-base single-crystal alloy, whereby the grain boundary strengthening elements are made to diffuse into only the surface of the Ni-base single-crystal alloy.

## Description

### Technical Field

This invention relates to Ni-base single-crystal alloys having a recrystallization crack-proof coating which can prevent intergranular cracks attributable to recrystallization.

### Background Art

Usually, the elements Zr (zirconium), Hf (hafnium), B (boron) and C (carbon) have the effect of strengthening grain boundaries in Nibase superalloys and are hence referred to as grain boundary strengthening elements or briefly as boundary strengthening elements. Since these elements exert an adverse influence on the intragranular structure and thereby cause a reduction in the strength of the Ni-base superalloy, it is common practice to add none of the aforesaid grain boundary strengthening elements, or only slight amounts thereof, to Ni-base single-crystal alloys having no grain boundary.

However, a strain may remain in the surface of a Ni-base single-crystal alloy having underwent a working operation such as cutting or grit blasting. When the Ni-base single-crystal alloy is subsequently used at high temperatures or exposed to high temperatures as a result of heat treatment or the like, recrystallization occurs in the Ni-base single-crystal alloy.

As described above, Ni-base single-crystal alloys contain no grain boundary strengthening elements or only slight amounts of grain boundary strengthening elements. Consequently, once recrystallization occurs in a Ni-base single-crystal alloy, its grain boundary regions have a lower strength than the interior of its crystal grains. This involves a problem in that the application of a low strain or stress produces cracks in the grain boundaries and these cracks cause a marked reduction in the material characteristics (e.g., creep strength and fatigue strength) of the Ni-base single-crystal alloy.

### Disclosure of the Invention

In view of the above-described existing state of the art, an object of the present invention is to provide a Ni-base single-crystal alloy containing no grain boundary strengthening elements or only slight amounts of grain boundary strengthening elements which alloy can prevent a reduction in strength that may occur in its grain boundary regions as a result of recrystallization.

According to the present invention, there is provided a Ni-base single-crystal alloy having a recrystallization crack-proof coating which is obtained by providing a Ni-base single-crystal alloy normally containing no grain boundary strengthening elements or only slight amounts of grain boundary strengthening elements, coating the surface of the Ni-base single-crystal alloy with a layer of a Ni-base alloy containing at least one or more grain boundary strengthening elements selected from the group consisting of Zr, Hf, B and C, and heat-treating the coated Ni-base single-crystal alloy at a temperature which does not cause recrystallization of the Ni-base single-crystal alloy, whereby the grain boundary strengthening elements are made to diffuse into only the surface or superficial region of the Ni-base single-crystal alloy.

In the case of a Ni-base single-crystal alloy, no grain boundary strengthening elements or only slight amounts of grain boundary strengthening elements are added thereto. Consequently, once recrystallization occurs, cracks will readily be initiated from grain boundaries to cause a marked reduction in the strength characteristics of the Ni-base single-crystal alloy. However, when one or more grain boundary strengthening elements selected from the group consisting of Zr, Hf, B and C are added, at least in amounts sufficient for grain boundary strengthening purposes, to only the close vicinity of its surface where recrystallization may occur, its grain boundaries will have higher strength even if recrystallization occurs, as compared with the case in which no grain boundary strengthening elements are added. Thus, it is possible to prevent the initiation of cracks from grain boundaries and thereby suppress a reduction in strength characteristics which is caused by recrystallization of the Ni-base single-crystal alloy. Moreover, since the grain boundary strengthening elements are present only in the superficial region of the Ni-base single-crystal alloy member (for example, in the range of 20 to 250 µm inwardly from the surface of the Ni-base single-crystal alloy), the addition of the grain boundary strengthening elements has little influence in reducing the strength of the base material.

### Best Mode for Carrying Out the Invention

First of all, a Ni-base alloy coating in the form of a layer is formed on the surface of a Ni-base single-crystal alloy member used as a base material.

This Ni-base single-crystal alloy member contains small amounts of elements having a grain boundary strengthening effect. As used herein, the expression "contain small amounts of elements having a grain boundary strengthening effect" means that no grain boundary strengthening elements or only slight amounts of grain boundary strengthening elements are added. Specifically, the Ni-base single-crystal alloy member contains not greater than 0.02 wt.% of Zr, not greater than 0.3 wt.% of Hf, not greater than 0.02 wt.% of C, and not greater than 0.01 wt.% of B. The aforesaid Ni-base alloy coating comprises a Ni-base alloy containing at least one or more grain boundary strengthening elements selected from the group consisting of Zr, Hf, B and C. The contents of the grain boundary strengthening elements present in the coating are such that it contains not greater than 0.1 wt.% of Zr, not greater than 10 wt.% of Hf, not greater than 0.1 wt.% of B, and not greater than 0.5 wt.% of C. Preferably, the lower limits thereof are 0.01 wt.% for Zr, 0.1 wt.% for Hf, 0.05 wt.% for B, and 0.01 wt.% for C. Moreover, it is desirable that, except for the grain boundary strengthening elements, the composition of the Ni-base alloy coating be substantially the same as or similar to that of the Ni-base single-crystal alloy member in order to enhance its adhesion to the Ni-base single-crystal alloy constituting the base material and minimize the diffusion of elements other than the grain boundary strengthening elements in the Ni-base alloy coating.

No particular limitation is placed on the method for forming the aforesaid Ni-base alloy coating on the surface of the Ni-base single-crystal alloy member, and there may be employed any of various methods such as thermal spraying, physical vapor deposition (including EB-PVD) and chemical vapor deposition. The thickness thereof is suitably in the range of 5 to 200 µm. The aforesaid Ni-base alloy coating may be applied when a Ni-base single-crystal alloy member is newly made or before a used Ni-base single-crystal alloy member is subjected to a reheating treatment for restoring its strength.

Subsequently, the aforesaid Ni-base single-crystal alloy member is heat-treated at a temperature which does not cause recrystallization thereof (e.g., a temperature of 800 to 1,300°C) for 50 to 0.5 hour. Thus, the grain boundary strengthening elements present in the aforesaid Ni-base alloy coating are made to diffuse, so that a recrystallization crack-proof coating (hereinafter also referred to as a recrystallization crack-resistant coating) is formed only in the surface of the Ni-base single-crystal alloy member. As used herein, the expression "heat-treated at a temperature of 800 to 1,300°C for 50 to 0.5 hour" means that the heat-treating time is 50 hours for a temperature of 800°C and 0.5 hour for a temperature of 1,300°C.

Examples of the aforesaid Ni-base single-crystal alloy (base material) to which the present invention is directed include CMSX-2, CMSX-4 (products of Cannon-Muskegon Corp., U.S.A.) and MC-2 (a product of Aubert & Duval, France), the compositions of which are shown in Table 1 below.

In Table 1, "Bal." shown for the Ni component means the balance, and all figures are expressed in terms of weight percentage.

**Table 1**

| Alloy | Ni | Cr | Co | Mo | W | Ta | Ti | Al | Re | Hf |
|---|---|---|---|---|---|---|---|---|---|---|
| CMSX-4 | Bal. | 7.9 | 4.6 | 0.6 | 8.0 | 6.0 | 1.0 | 5.6 | - | - |
| CMSX-2 | Bal. | 6.4 | 9.7 | 0.6 | 6.4 | 6.5 | 1.0 | 5.7 | 2.9 | 0.1 |
| MC-2 | Bal. | 7.8 | 5.1 | 2.1 | 7.8 | 6.0 | 1.5 | 5.0 | - | - |

One example of the Ni-base alloy containing grain boundary strengthening elements is CM247 (a product of Cannon-Muskegon Corp., U.S.A.) that is a conventionally known alloy containing Zr, Hf, B and C. The typical composition of this CM247 consists of, on a weight percentage basis, 8.2% Cr, 10.0% Co, 0.6% Mo, 10.0% W, 3.0% Ta, 1.0% Ti, 5.5% Al, 0.020% B, 0.16% C, 0.09% Zr, 1.5% Hf and the balance being Ni.

### Examples

In order to demonstrate the effects of the present invention more clearly, the following examples are given.

### Example 1

In Example 1, CMSX-2 (a product of Cannon-Muskegon Corp.) which is described in U.S. Patent No. 4,582,548 was used as a Ni-base single-crystal alloy member constituting the base material. The typical composition of this CMSX-2 consists of, on a weight percentage basis, 4.3-4.9% Co, 7.5-8.2% Cr, 0.3-0.7% Mo, 7.6-8.4% W, 5.8-6.2% Ta, 5.45-6.2% Al, 0.8-1.2% Ti, and the balance being Ni.

First of all, the aforesaid Ni-base single-crystal alloy member was grit-blasted to give a working strain to its surface. Thereafter, a Ni-base alloy coating serving as a recrystallization crack-proof coating was formed thereon to a thickness of about 100 µm by low-pressure plasma spraying. The composition of the Ni-base alloy coating consisted of, on a weight percentage basis, 0.1% Zr, 0.1% B, 7.5% Cr, 4% Co, 0.5% Mo, 7.5% W, 6% Ta, 1% Ti, 5.5% Al, and the balance being Ni. Subsequently, the coated Ni-base single-crystal alloy member was performed a vacuum heat treatment at 1,100°C for 8 hours so as to cause Zr and B present in the aforesaid recrystallization crack-proof coating to diffuse into the Ni-base single-crystal alloy constituting the base material, and then heat-treated at 1,200°C for 4 hours so as to simulate a solution treatment for CMSX-2 single-crystal alloy. The Ni-base single-crystal alloy member thus obtained was referred to as inventive material 1.

Moreover, for purposes of comparison, comparative materials ①, ② and ③ were prepared according to the respective procedures described below. Specifically, comparative material ① was prepared by grit-blasting CMSX-2 single-crystal alloy to give a working strain to its surface, and then heat-treating it at 1,200°C for 4 hours. Comparative material ② was prepared by heat-treating CMSX-2 single-crystal alloy at 1,200°C for 4 hours without grit-blasting it to give a working strain to its surface. Comparative material ③ was prepared by grit-blasting CMSX-2 single-crystal alloy to give a working strain to its surface, forming thereon a coating having the same composition as CMSX-2 free of Zr, Hf, B and C to a thickness of about 100 micrometers by low-pressure plasma spraying, and then heat-treating it at 1,200°C for 4 hours. This heat treatment was carried out in a vacuum at a temperature of 1,200°C for 4 hours. These test materials are summarized in Table 2.

**Table 2**

| Test material | Grit blasting | Presence of recrystallization crack-proof coating | Recrystallization after heat treatment |
|---|---|---|---|
| Inventive material 1 | Yes | Yes | Yes |
| Comparative material ① | Yes | No | Yes |
| Comparative material ② | No | No | No |
| Comparative material ③ | Yes | No (except for the formation of a coating containing neither Zr nor B and having the same composition as CMSX-2 constituting the base material) | Yes |

With respect to these inventive material 1 and comparative materials, the occurrence of recrystallization was ascertained by observing the microstructure of a section of each material. As a result, for inventive material 1 and comparative materials ① and ③, an about 10 micrometers wide recrystallization layer was observed in the surface of the CMSX-2 single-crystal alloy (in the case of inventive material 1, on the single-crystal alloy side of the interface between the CMSX-2 single-crystal alloy and the recrystallization crack-proof coating). However, no recrystallization layer was observed in comparative material ②.

Subsequently, material characteristics were evaluated by a high cycle fatigue test. This high cycle fatigue test was carried out according to Ono's rotary bending method under conditions including a test temperature of 900°C, a stress amplitude of 40 kg/mm², and a frequency of 60 Hz. The results thus obtained are shown in Table 3.

**Table 3**

| Test material | Failure life (relative value based on the life of comparative material ② taken as 1) |
|---|---|
| Inventive material 1 | 0.8 |
| Comparative material ① | 0.4 |
| Comparative material ② | 1 |
| Comparative material ③ | 0.3 |
| * Conditions of high cycle fatigue test (Ono's Rotary Bending Test JIS Z 2274) Test temperature: 900°C Stress: 40 kg/mm² Frequency: 60 Hz | |

As shown in this Table 3, a comparison of comparative material ① with comparative material ② reveals that the former clearly shows a reduction in failure life due to recrystallization. On the other hand, inventive material 1 shows a reduction in life as compared with comparative material ② in which no recrystallization occurred, but has a distinctly longer life than comparative material ①. Moreover, inventive material 1 also has a distinctly longer life than comparative material ③, clearly indicating the effect of Zr and B present in the coating.

### Example 2

In Example 2, CMSX-2 was used as a single-crystal alloy constituting the base material. The composition of this CMSX-2 consists of, on a weight percentage basis, 7.9% Cr, 4.6% Co, 0.6% Mo, 8.0% W, 6% Ta, 1% Ti, 5.6% Al, and the balance being Ni.

First of all, a member of this single-crystal alloy was grit-blasted to give a working strain to its surface. Thereafter, a Ni-base alloy coating serving as a recrystallization crack-proof coating was formed thereon to a thickness of about 100 micrometers by physical vapor deposition. The composition of this Ni-base alloy coating consisted of, on a weight percentage basis, 3.0% Zr, 0.2% C, 7.5% Cr, 4% Co, 0.5% Mo, 7.5% W, 6% Ta, 1% Ti, 5.5% Al, and the balance being Ni. Subsequently, the coated single-crystal alloy member was heat-treated performed a vacuum heat treatment at 1,100°C for 8 hours so as to cause Hf and C present in the Ni-base alloy coating to diffuse into the single-crystal alloy, and then heat-treated at 1,200°C for 4 hours so as to simulate a solution treatment for CMSX-2 single-crystal alloy. The single-crystal alloy member thus obtained was referred to as inventive material 2.

Moreover, for purposes of comparison, comparative materials ④, ⑤ and ⑥ were prepared according to the respective procedures described below. Specifically, comparative material ④ was prepared by grit-blasting CMSX-2 single-crystal alloy to give a working strain to its surface, and then heat-treating it at 1,200°C for 4 hours. Comparative material ⑤ was prepared by heat-treating CMSX-2 single-crystal alloy at 1,200°C for 4 hours without grit-blasting it to give a working strain to its surface. Comparative material ⑥ was prepared by grit-blasting CMSX-2 single-crystal alloy to give a working strain to its surface, forming thereon a coating having the same composition as CMSX-2 free of Zr, Hf, B and C to a thickness of about 100 micrometers by physical vapor deposition, and then heat-treating it at 1,200°C for 4 hours. This heat treatment was carried out in a vacuum at a temperature of 1,200°C for 4 hours. These test materials are summarized in Table 4.

**Table 4**

| Test material | Grit blasting | Presence of recrystallization crack-proof coating | Recrystallization after heat treatment |
|---|---|---|---|
| Inventive material 2 | Yes | Yes | Yes |
| Comparative material ④ | Yes | No | Yes |
| Comparative material ⑤ | No | No | No |
| Comparative material ⑥ | Yes | No (except for the formation of a coating containing neither Zr nor B and having the same composition as CMSX-2 constituting the base material) | Yes |

With respect to these inventive material 2 and comparative materials, the occurrence of recrystallization was ascertained by observing the microstructure of a section of each material. As a result, for inventive material 2 and comparative materials ④ and ⑥, an about 10 micrometers wide recrystallization layer was observed in the surface of the CMSX-2 single-crystal alloy (in the case of inventive material 2, on the single-crystal alloy side of the interface between the CMSX-2 single-crystal alloy and the recrystallization crack-proof coating). However, no recrystallization layer was observed in comparative material ⑤.

Subsequently, material characteristics were evaluated by a high cycle fatigue test. This high cycle fatigue test was carried out according to Ono's rotary bending method under conditions including a test temperature of 900°C, an applied stress of 40 kg/mm², and a frequency of 60 Hz. The results thus obtained are shown in Table 5.

**Table 5**

| Test material | Failure life (relative value based on the life of comparative material ⑤ taken as 1) |
|---|---|
| Inventive material 1 | 0.7 |
| Comparative material ④ | 0.4 |
| Comparative material ⑤ | 1 |
| Comparative material ⑥ | 0.3 |
| * Conditions of high cycle fatigue test (Ono's Rotary Bending Test JIS Z 2274) Test temperature: 900°C Stress: 40 kg/mm² Frequency: 60 Hz | |

As shown in the above Table 5, a comparison of comparative material ④ with comparative material ⑤ reveals that the former clearly shows a reduction in failure life due to recrystallization. On the other hand, inventive material 2 shows a reduction in life as compared with comparative material ⑤ in which no recrystallization occurred, but has a distinctly longer life than comparative material ④. Moreover, inventive material 2 also has a distinctly longer life than comparative material ⑥, clearly indicating the effect of HF and C present in the recrystallization crack-proof coating.

### Example 3

In Example 3, CMSX-2 was used as a single-crystal alloy constituting the base material. The composition of this CMSX-2 consists of, on a weight percentage basis, 7.9% Cr, 4.6% Co, 0.6% Mo, 8.0% W, 6% Ta, 1% Ti, 5.6% Al, and the balance being Ni.

First of all, two members of this single-crystal alloy were grit-blasted to give a working strain to their surfaces. Thereafter, two types of Ni-base alloy coatings serving as recrystallization crack-proof coatings were separately formed thereon to a thickness of about 200 micrometers by ultrahigh speed flame spraying. The composition of a first Ni-base alloy coating (inventive material 3) consisted of, on a weight percentage basis, 0.1% Zr, 0.1% B, 0.1% C, 7.5% Cr, 4% Co, 0.5% Mo, 7.5% W, 6% Ta, 1% Ti, 5.5% Al, and the balance being Ni, while the composition of a second Ni-base alloy coating (inventive material 4) consisted of, on a weight percentage basis, 0.3% C, 7.5% Cr, 4% Co, 0.5% Mo, 7.5% W, 6% Ta, 1% Ti, 5.5% Al, and the balance being Ni. Subsequently, the coated single-crystal alloy members were performed a vacuum heat treatment at 1,100°C for 8 hours so as to cause Zr, B and C present in the Ni-base alloy coating to diffuse into the single-crystal alloy, and then heat-treated at 1,200°C for 4 hours so as to simulate a solution treatment for CMSX-2 single-crystal alloy.

Moreover, for purposes of comparison, comparative materials ⑦, ⑧ and ⑨ ere prepared according to the respective procedures described below. Specifically, comparative material ⑦ was prepared by grit-blasting CMSX-2 single-crystal alloy to give a working strain to its surface, and then heat-treating it at 1,200°C for 4 hours. Comparative material ⑧ was prepared by heat-treating CMSX-2 single-crystal alloy at 1,200°C for 4 hours without grit-blasting it to give a working strain to its surface. Comparative material ⑨ was prepared by grit-blasting CMSX-2 single-crystal alloy to give a working strain to its surface, forming thereon a coating having the same composition as CMSX-2 free of Zr, Hf, B and C to a thickness of about 200 micrometers by high speed flame spraying, and then heat-treating it at 1,200°C for 4 hours. This heat treatment was carried out in a vacuum at a temperature of 1,200°C for 4 hours. These test materials are summarized in Table 6.

**Table 6**

| Test material | Grit blasting | Presence of recrystallization crack-proof coating | Recrystallization after heat treatment |
|---|---|---|---|
| Inventive material 3 | Yes | Yes | Yes |
| Inventive material 4 | Yes | Yes | Yes |
| Comparative material ⑦ | Yes | No | Yes |
| Comparative material ⑧ | No | No | No |
| Comparative material ⑨ | Yes | No (except for the formation of a coating containing none of Zr, B, etc. and having the same composition as CMSX-2 constituting the base material) | Yes |

With respect to these inventive materials 3 and 4 and comparative materials, the occurrence of recrystallization was ascertained by observing the microstructure of a section of each material. As a result, for inventive materials 3 and 4 and comparative materials ⑦ and ⑨, an about 10 micrometers wide recrystallization layer was observed in the surface of the CMSX-2 single-crystal alloy (in the case of inventive materials 3 and 4, on the single-crystal alloy side of the interface between the CMSX-2 single-crystal alloy and the recrystallization crack-proof coating). However, no recrystallization layer was observed in comparative material ⑧.

Subsequently, material characteristics were evaluated by a high cycle fatigue test. This high cycle fatigue test was carried out according to Ono's rotary bending method under conditions including a test temperature of 900°C, an applied stress of 40 kg/mm², and a frequency of 60 Hz. The results thus obtained are shown in Table 7.

**Table 7**

| Test material | Failure life (relative value based on the life of comparative material ⑧ taken as 1) |
|---|---|
| Inventive material 3 | 0.7 |
| Inventive material 4 | 0.6 |
| Comparative material ⑦ | 0.4 |
| Comparative material ⑧ | 1 |
| Comparative material ⑨ | 0.3 |
| * Conditions of high cycle fatigue test (Ono's Rotary Bending Test JIS Z 2274) Test temperature: 900°C Stress: 40 kg/mm² Frequency: 60 Hz | |

As shown in the above Table 7, a comparison of comparative material ⑦ with comparative material ⑧ reveals that the former clearly shows a reduction in failure life due to recrystallization. On the other hand, inventive materials 3 and 4 show a reduction in life as compared with comparative material ⑧ in which no recrystallization occurred, but have a distinctly longer life than comparative material ⑦. Moreover, inventive materials 3 and 4 also have a distinctly longer life than comparative material ⑨, clearly indicating the effect of the combined addition of B and C, or the addition of C alone, to the recrystallization crack-proof coating.

### Exploitability in Industry

The present invention may be utilized, for example, to treat turbine blades for use at high temperatures and thereby strengthen the surfaces thereof.

Moreover, in Ni-base single-crystal alloys having a recrystallization crack-proof coating in accordance with the present invention, the grain boundaries formed during recrystallization can be strengthened to improve their material strength characteristics after recrystallization.

## Claims

1. A Ni-base single-crystal alloy having a recrystallization crack-proof coating which is obtained by providing a Ni-base single-crystal alloy containing small amounts of elements having a grain boundary strengthening effect, coating the surface of the Ni-base single-crystal alloy with a layer of a Ni-base alloy containing at least one or more grain boundary strengthening elements selected from the group consisting of Zr, Hf, B and C to form a Ni-base alloy coating, and heat-treating the coated Ni-base single-crystal alloy at a temperature which does not cause recrystallization of the Ni-base single-crystal alloy, whereby a recrystallization crack-proof coating layer into which said grain boundary strengthening elements have diffused is formed only in the surface of the Ni-base single-crystal alloy.

2. A Ni-base single-crystal alloy having a recrystallization crack-proof coating as claimed in claim 1 wherein the composition of said Ni-base single-crystal alloy contains not greater than 0.02 wt.% of Zr, not greater than 0.3 wt.% of Hf, not greater than 0.02 wt.% of C, and not greater than 0.01 wt.% of B.

3. A Ni-base single-crystal alloy having a recrystallization crack-proof coating as claimed in claim 1 or 2 wherein the composition of said Ni-base alloy coating contains at least one or more elements selected from the group consisting of not greater than 0.1 wt.% of Zr, not greater than 10 wt.% of Hf, not greater than 0.1 wt.% of B, and not greater than 0.5 wt.% of C.
